# EUROPEAN PATENT APPLICATION

(11) **EP 0 978 765 A2**
(43) Date of publication of application: **09.02.2000**
(21) Application number: 99107386.7
(22) Date of filing: 23.04.1999
(51) Int. Cl.: G03F 9/00

(54) **Positioning mark and alignment method using the same**

(30) Priority: 06.08.1998 JP 22313098
(71) Applicant: SANEI GIKEN CO., LTD., Amagasaki-shi, Hyogo-ken (JP)
(72) Inventor: Miyake, Eiichi, c/o Sanei Giken Co.Ltd., Amagasaki-shi, Hyogo-ken (JP)
(74) Representative: HOFFMANN - EITLE

(57) **Abstract**

Each of positioning marks comprises a plurality of mark elements. The mark elements are adapted to be individually determined for their respective positions and configurations. A reference point of the positioning mark is located on the basis of data obtained by determining respective positions and configurations of the mark elements.

## Description

The present invention relates to a positioning mark and method of positional alignment using the same. The positioning mark is adapted to indicate a particular position on a surface on which the positioning mark is provided.

More particularly, the invention relates to positioning marks suitable to be used as alignment marks when a photo-mask and a substrate are aligned with each other during an exposure process in which a pattern drawn on the photo-mask is transferred onto the substrate by irradiating a light through the photo-mask onto the substrate, in order to manufacture, for example, a printed circuit board. The invention relates specifically to a method of performing positional alignment between a photo-mask and a substrate with the aid of the aforesaid positioning marks during the exposure process.

It is known in the art to determine a positioning mark by means of a CCD. It is important for the positioning mark to be optically and definitely determined by means of a CCD camera. For example, a positioning mark may be provided by a through-hole formed in an opaque or non-transparent, flat plate. Such a positioning mark may be determined by means of a CCD camera with a transmitted light. In this case, a definite contrast is obtained, and thus an accurate determining and a subsequent image processing may be performed in most cases.

On the other hand, in the case that a positioning mark is provided by a blind-hole formed in a flat plate, only an ambiguous contrast is obtained when the positioning mark is determined by a CCD camera with a reflected light. It is also noted that disturbance is included in the thus obtained image due to irregular reflection of the light. Thus, it is difficult to obtain an accurate image in most cases.

Recently, it has been required that the alignment mark (positioning mark) provided by a blind-hole is accurately determined when performing inter-layer alignment during the aforementioned exposure process. Specifically, a printed circuit board has become multi-layered in recent years and thus high accuracy has been required when performing the inter-layer alignment. Consequently, it is frequently required that the alignment mark is provided by a blind-hole and accurately determined by a CCD camera with a reflected light.

The blind-hole is formed in a substrate by drilling, or removal of a photosensitive layer through the use of laser or exposure process. It is noted, however, that, in such a case, certain disadvantages, such as ambiguousness in contrast and disturbance of an image due to irregular reflection of the light may be experienced, as compared to the case in which a through-hole provides a positioning mark, as mentioned before. It is also noted that it is likely that the edge of the blind-hole is unevenly ground during a surface polishing process is performed after the blind-hole has been formed. This uneven grinding causes deformation of the blind-hole. A photosensitive film to be used a subsequent process is laminated on the surface of the substrate. This film sometimes covers the region including the blind-holes. In such a case, a portion of the photosensitive material tends to flow into the hole, so that the contour of the hole disadvantageously becomes ambiguous or unclear. Consequently, it has been difficult that the blind-hole is determined accurately by a CCD camera with a reflected light, for example, on the basis of the difference in color between the surface of the substrate and the bottom of the blind-hole.

It has been difficult that the mark provided by a blind-hole is determined accurately as mentioned above. However, it has been found that when a diameter of a blind-hole providing a positioning mark is reduced, a CCD camera can determine such a positioning mark as an image which has a tremendously improved sharpness or clearness. In particular, when the diameter size of the hole is reduced, the degree of deformation due to the uneven grinding of the edge of the hole, which is caused during the surface polishing process mentioned above, will be significantly reduced. It is also noted that, when a photosensitive film is laminated over such a small hole, no substantial portion of the photosensitive material flows, in practice, into the hole, so that the phenomenon of optical disturbance is difficult to be occurred. Accordingly, a CCD camera is enabled to accurately determine a definite or sharp contour of the configuration of the mark with a reflected light, when the hole providing the mark is reduced in its diameter.

It is further noted that a small mark can be accurately determined by a CCD camera even when such a small mark is provided by means other than the aforementioned hole, for example, by a formation having a convex cross-section, or an area colored so as to be distinguished from the region surrounding it, wherein the mark is used under the circumstance in which the mark is not influenced by the problem of the aforementioned polishing or photosensitive material.

It is noted, however, that another problem would occur, when the mark is reduced in its size or diameter. Specifically, if an alignment mark, which is to be used, for example, during the above-mentioned exposure process and which may be accurately determined, has a diameter from 0.3 mm to 0.03 mm, it is necessary for the lens of the CCD camera to be increased in its magnification. Because, the above diameter is several times smaller than the diameter of an existing alignment mark (approximately 3.0 mm to 0.5 mm). When the lens of the CCD camera is increased in its magnification, the field of view of the CCD camera becomes substantially narrower and, therefore, it is difficult for the alignment mark to be rapidly located within the narrower field of view of the CCD camera. In other words, a considerable degree of carefulness is required in positioning the substrate having the alignment marks relative to the CCD camera. In particular, in the case that a positional alignment operation is performed by an automatically operated machine, several disadvantages, such as reduction in production rate and increase in equipment cost, would be resulted, if a considerable degree of carefulness is required during the positioning of the substrate.

Even when the mark is provided by means other than the hole, for example, by a formation having a convex cross-section, or an area colored so as to be distinguished from the region surrounding it, it is also required that the lens of the CCD camera for determining the mark should be increased in its magnification, provided that the mark is reduced in its size or diameter.

Accordingly, it is an object of the invention to provide a mark (when a hole is formed in a substrate so as to be used as an alignment mark during exposure process, a smaller hole is preferred for the reason mentioned above) to be used as a positioning mark, which may be accurately determined by a CCD camera, without requiring increase of the magnification of the CCD camera or without needing reduction of the field of view of the CCD camera.

In accordance with the invention, a positioning mark to be provided on a flat surface comprises a plurality of mark elements. The mark elements are adapted to be individually determined for their respective positions and configurations. Whereby a reference point of the positioning mark can be located on the basis of data regarding the determined respective positions and configurations of the mark elements.

Each of the mark elements may have a concave or convex configuration in its cross-section.

Each of the mark elements may be provided by a through-hole extending through a member having the flat surface, or a blind-hole formed in the flat surface.

The mark elements may be arranged in a circular array.

The mark elements may be arranged in two linear arrays crossing perpendicularly each other.

The positioning mark may be an alignment mark which is used in connection with a separate positioning mark provided on a separate flat surface at a position corresponding to the position of the alignment mark, so as to perform positional alignment between the flat surface and the separate flat surface.

A plurality of the positioning marks may be provided on the flat surface at positions spaced apart from one another, so that the positioning marks can be used to determine the distance between any two of the positioning marks.

In accordance with the invention, a method of positional alignment is also provided which comprises the steps of:
providing a plurality of positioning marks, as a first set of alignment marks, on a first flat plate at positions spaced apart from one another;
providing a plurality of positioning marks, as a second set of alignment marks, on a second flat plate at the positions corresponding to the positions of the first set of alignment marks, respectively;
at least confined areas in which the positioning marks are provided on at least one of the first and second flat plates being optically transparent;
placing the first and second flat plates in contact or in closely adjacent relationship with each other, so that the first set of alignment marks and the second set of alignment marks are overlapped each other, respectively;
determining the respective positions of each pair of the overlapped first and second alignment marks, and obtaining the amount of misregistration between each pair of the overlapped first and second alignment marks on the basis of data regarding the determined respective positions of each pair of the overlapped first and second alignment marks; and
moving one of the first and second flat plates in X, Y or theta directions on the basis of the amount of misregistration, so as to perform a positional alignment between the first and second flat plates;
wherein each alignment mark of at least one set of alignment marks comprises a plurality of mark elements;
wherein the mark elements are adapted to be individually determined for their respective positions and configurations; and
wherein the position of each alignment mark of aforesaid at least one set of alignment marks is determined by locating a reference point of the alignment mark on the basis of data obtained by determining respective positions and configurations of mark elements.

The first and second flat plates may be a photo-mask and a substrate, respectively, which are used in an exposure process in which a pattern drawn on the photo-mask is transferred onto the substrate by irradiating a light through the photo-mask onto the substrate.

Each alignment mark of aforesaid at least one set of alignment marks may be a formation which is provided within the pattern drawn on the photo-mask for separate purpose.
Fig. 1A is a schematic plan view showing how a substrate and a photo-mask are aligned with each other, in which an existing positioning mark is used;
Fig. 1B is a schematic plan view showing how a substrate and a photo-mask are aligned with each other, in which a positioning mark according to one form of the invention is used;
Fig. 2 is a schematic, cross-sectional view showing how the substrate and the photo-mask are aligned with each other using a CCD camera, in which an existing positioning mark (alignment mark) comprising a blind-hole formed in the substrate;
Fig. 3A shows a sectional view of a relatively large blind-hole which is used as an existing positioning mark (lower figure), and a plan view of the same blind-hole when viewed from the above by a CCD camera as an image (upper figure), respectively;
Fig. 3B shows a sectional view of a relatively small blind-hole which is used as a mark element of a positioning mark according to one form of the invention (lower figure), and a plan view of the same blind-hole when viewed from the above by a CCD camera as an image (upper figure), respectively;
Figs. 4A, 4B and 4C are plan views showing three exemplary types of configurations of the positioning mark according to one form of the invention; (A) shows a positioning mark comprising mark elements which are arranged in a circular array; (B) shows a positioning mark comprising mark elements which are arranged in two linear arrays crossing perpendicularly each other; and (C) shows a positioning mark comprising mark elements which are arranged in two linear arrays parallel to each other, respectively;

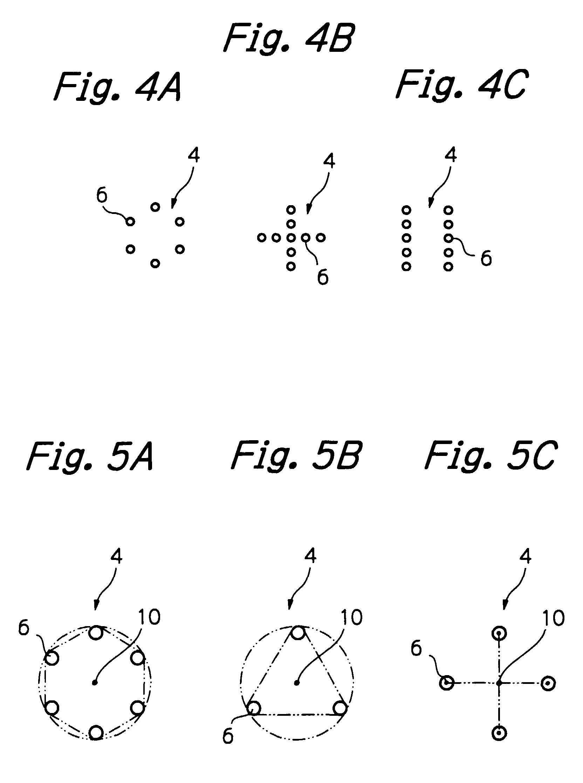

Figs. 5A, 5B and 5C are plan views each showing how a reference position (the center of figure in this case) of the positioning mark according to one form of the invention is located on the basis of the positions of the mark elements or the distances between the mark elements; in (A) a reference position of the positioning mark is located by obtaining the center of a figure, that is a circle or a polygon which circumscribes the mark elements; in (B) a reference position is also located by obtaining the center of a circle or a triangle which circumscribes the three mark elements; and in (C) a reference position of the positioning mark is located by obtaining the intersection of the two lines each connecting the opposed pair of mark elements of the four mark elements, respectively; and:
Figs. 6A and 6B are plan views, in part, of the substrate and the photo-mask, showing how the substrate and the photo-mask are aligned with each other using the positioning mark according to one form of the invention, wherein (A) is a case in which the positioning mark according to one form of the invention is provided on both of the substrate and the photo-mask, and (B) is a case in which the positioning mark according to one form of the invention is provided on the substrate and an existing positioning mark is provided on the photo-mask.

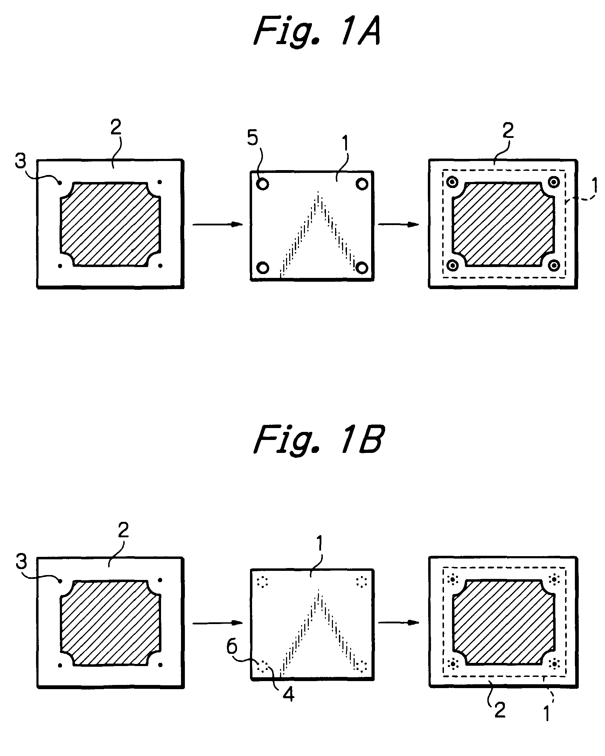

Figs. 1A and 1B show how a substrate 1 and a photo-mask 2 are aligned with each other during exposure process. Fig. 1A shows a case in which an existing positioning mark is used, while Fig. 1B shows a case in which a positioning mark according to one form of the invention is used. The photo-mask 2 is provided with a plurality of positioning marks 3 to be used as alignment marks. A predetermined pattern, such as wiring pattern, to be transferred onto the substrate 1 is drawn on a surface of the photo-mask 2 at the central portion (crosshatched portion in Fig. 1) thereof. The area surrounding the pattern is transparent. Within the transparent area, a plurality of positioning marks 3, such as blackened circles, are provided.

Each of existing positioning marks 5 provided on the substrate 1 is in the form of a recess defined by a relatively larger blind-hole. On the other hand, each of positioning marks 4 according to one form of the invention provided on the substrate 1 comprises a plurality of mark elements 6 each of which is in the form of a relatively smaller blind-hole. In this example, each positioning mark 4 is formed by the mark elements 6 arranged in a circular array.

The substrate 1 and the photo-mask 2 are superposed on one another so that the corresponding positioning marks are overlapped one another, as shown in Fig. 1 at the right-hand figure thereof. A CCD camera determines each pair of the overlapped marks from the above, and the substrate 1 and the photo-mask are aligned with each other. After completion of the alignment operation, a light is irradiated through the photo-mask onto the substrate 1, so as to perform exposure process. By this, the pattern on the photo-mask 2 is transferred onto the substrate 1.

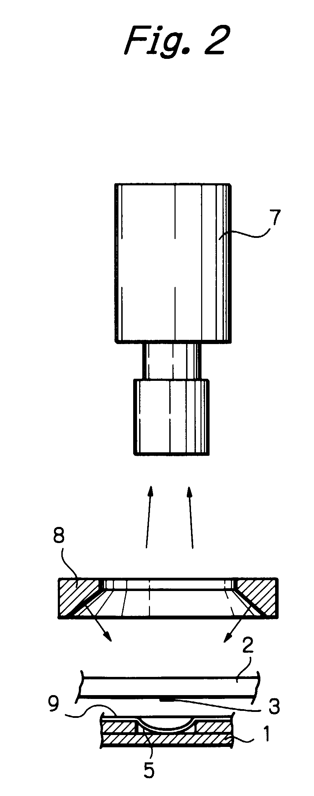

Fig. 2 shows how the existing positioning mark 5, provided on the substrate 1, is aligned with the positioning mark 3 provided on the photo-mask by means of a CCD camera 7. The positioning mark 5 is in the form of a relatively larger blind-hole, and the positioning marks 3 has a protruded cross-sectional. The area of the photo-mask 2 surrounding the positioning mark 3 is transparent to light. First, the substrate 1 and the photo-mask 2 are brought close to one another and positioned properly, in a manner that the corresponding positioning marks 3 and 5 are overlapped with each other. It is noted that, depending on the cases, the substrate 1 and the photo-mask 2 may be positioned in contact with each other. Then, lighting equipment 8 of an annular configuration emits a light to irradiate the positioning marks 3 and 5. The CCD camera 7 receives reflected light and determines each of the positioning marks 3 and 5 so as to obtain data relating to positions thereof. From the data, the amount of misregistration between the positioning marks 3 and 5 are determined. Then, the substrate 1 or photo-mask 2 is moved in X, Y or theta direction on the basis of the amount of misregistration, so as to cause the each pair of the positioning marks 3 and 5 to be accurately aligned with each other. Thus, the substrate 1 and the photo-mask may be aligned with each other.

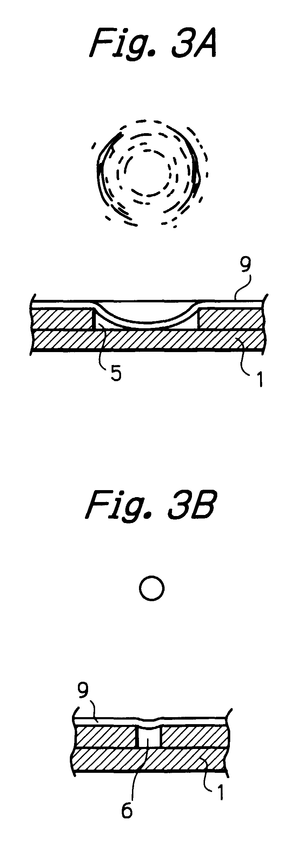

It is noted that, when a relatively larger blind-hole is used as the existing positioning mark 5, a portion of photosensitive material 9 applied on the substrate 1 tends to flow into the hole, as shown in Fig. 3A. This causes a monochrome image obtained by the CCD camera to be ambiguous in its contour, as shown in Fig. 3A at its upper figure. Accordingly, accurate determining of the positioning mark 5 could not be performed.

On the contrary and when the positioning mark 4 comprises a plurality of mark elements 6 each being formed by a relatively smaller blind-hole in accordance with the invention, the photosensitive material 9 does not tend in practice to flow into any holes constituting the mark elements 6. This causes an image obtained by the CCD camera to be sharp in its contour, as shown in Fig. 3B at its upper figure. Thus, accurate determining can be performed.

Figs. 4A - 4C show three embodiments in each of which the positioning mark 4 comprises a plurality of relatively smaller mark elements 6 in accordance with the invention. In embodiment (A), the mark elements 6 are arranged in a circular array; in embodiment (B), the mark elements 6 are arranged in two arrays crossing each other; and, in embodiment (C), the mark elements 6 are arranged in two parallel linear arrays. It is noted, however, that an arrangement of the mark elements 6 is not restricted to those in the above-mentioned embodiments.

It is also noted that each mark element 6 may be a formation having a concave or convex cross-section, a through-hole or the like, in addition to the above-mentioned blind-hole.

In the illustrated embodiments, all of the holes constituting a set of the mark elements 6 have the same diameter. It is noted, however, that a set of the mark elements 6 may include a several kinds of holes having different diameters, so that the positioning mark 4 comprises a plurality of holes having different diameters.

With reference to Figs. 5A - 5C, a process or method will be explained for locating a reference position (a center of figure in this case) of the positioning mark 4 from the positions and configurations of and the distance between the plurality of mark elements 6 constituting the positioning mark 4 in accordance with the invention. In Fig. 5A, a reference position 10 of the positioning mark 4 may be determined by obtaining the center of a figure, such as a circle, a polygon or the like which circumscribes the mark elements 6. In Fig. 5B, a reference position 10 may also be located by obtaining the center of a circle or a triangle which circumscribes the three mark elements 6. In Fig. 5C, a reference position 10 of the positioning mark 4 may be located by obtaining the intersection of the lines each connecting the opposed pair of mark elements 6 of the four mark elements 6. In addition to the center of figure, center of gravity or the like may be selectively used as a reference position of the positioning mark 4.

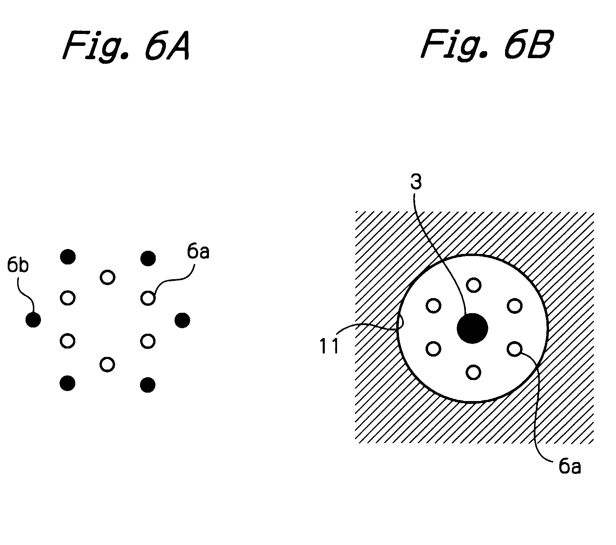

When the positioning mark 4 according to one form of the invention is used for the purpose of aligning two flat plates with each other, the positioning mark 4 may be provided on one or both of the flat plates. For example, when the positioning mark 4 is used for the purpose of aligning the substrate 1 and the photo-mask 2 with each other during exposure process, the positioning mark for the substrate 1 may include a plurality of mark elements 6a, while the positioning mark for the photo-mask may include a plurality of mark elements 6b, as shown in Fig. 6A. Alternatively, the positioning mark for the substrate 1 may include a plurality of mark elements 6a, while the positioning mark for the photo-mask may include an existing positioning mark 3, as shown in Fig. 6B. It is noted that, in the illustrated embodiments, the area surrounding the positioning mark is optically transparent, but the region outside the circular mark 11 of a mask is not transparent.

As will be appreciated from the foregoing, the positioning mark according to one form of the invention may be used when two flat plates are aligned with each other. It is noted, however, that a plurality of positioning marks according to one form of the invention may be provided on a single flat plate, so as to determine the distance between the positioning marks, or so as to make inspection of measurement equipment on the basis of the thus obtained distance.

It is also noted that the positioning mark according to one aspect of the invention may include one or more formations provided, for different purpose, within a pattern drawn on the photo-mask.

In accordance with one aspect of the invention, a positioning mark comprises a plurality of mark elements. The position of each of the mark elements can be determined individually. Thus, the reference position of the positioning mark can be located on the basis of the determined respective positions and configurations of the mark elements. Accordingly, even when "holes", which are difficult to be accurately determined under some environment, are to be employed as positioning marks, it is possible to provide mark elements having reduced diameters which may be accurately determined or identified. The small mark elements collectively form a relatively larger positioning mark. This positioning mark may have a size corresponding to that of existing positioning mark. Thus, it is not necessary for a CCD camera to be increased in its magnification, which would reduce the field of view of the camera, when the positioning mark is roughly aligned relative to the CCD camera for determining the positioning mark, whereby efficient alignment operation can be performed. A reference position of the positioning mark, such as the center of figure, can be accurately located on the basis of the data obtained accurately with regard to the mark elements.

## Claims

1. A positioning mark to be provided on a flat surface, wherein:
said positioning mark comprises a plurality of mark elements;
said mark elements are adapted to be individually determined for their respective positions and configurations; and
whereby a reference point of said positioning mark can be located on the basis of data regarding the determined respective positions and configurations of said mark elements.

2. A positioning mark according to Claim 1, wherein each of said mark elements has a concave or convex configuration in its cross-section.

3. A positioning mark according to Claim 1, wherein each of said mark elements is defined by a through-hole extending through a member having said flat surface, or a blind-hole formed in said flat surface.

4. A positioning mark according to any one of Claims 1 to 3, wherein said mark elements are arranged in a circular array.

5. A positioning mark according to any one of Claims 1 to 3, wherein said mark elements are arranged in two linear arrays crossing perpendicularly each other.

6. A positioning mark according to any one of Claims 1 to 5, wherein said positioning mark is an alignment mark which is used in connection with a separate positioning mark provided on a separate flat surface at a position corresponding to said alignment mark, so as to perform positional alignment between said flat surface and said separate flat surface.

7. A positioning mark according to any one of Claims 1 to 5, wherein a plurality of said positioning marks are provided on said flat surface at positions spaced apart from one another, so that said positioning marks can be used to determine the distance between any two of said positioning marks.

8. A method of positional alignment comprising the steps of:
providing a plurality of positioning marks, as a first set of alignment marks, on a first flat plate at positions spaced apart from one another;
providing a plurality of positioning marks, as a second set of alignment marks, on a second flat plate at the positions corresponding to the positions of said first set of alignment marks, respectively;
at least confined areas in which the positioning marks are provided on at least one of said first and second flat plates being optically transparent;
placing said first and second flat plates in contact or in closely adjacent relationship with each other, so that said first set of alignment marks and said second set of alignment marks are overlapped each other, respectively;
determining the respective positions of each pair of the overlapped first and second alignment marks, and obtaining the amount of misregistration between each pair of said overlapped first and second alignment marks on the basis of data regarding the determined respective positions of each pair of the overlapped first and second alignment marks; and
moving one of said first and second flat plates in X, Y, or theta direction on the basis of said amount of misregistration, so as to perform a positional alignment between said first and second flat plates;
wherein each alignment mark of at least one set of alignment marks comprises a plurality of mark elements;
wherein said mark elements are adapted to be individually determined for their respective positions and configurations; and
wherein the position of each alignment mark of said at least one set of alignment marks is determined by locating a reference point of the alignment mark on the basis of data obtained by determining respective positions and configurations of said mark elements.

9. A method of positional alignment according to Claim 8, wherein said reference point is the center of figure of the alignment mark.

10. A method of positional alignment according to Claim 8 or 9, wherein said mark elements are determined by a CCD camera.

11. A method of positional alignment according to any one of Claims 8 - 10, wherein said first and second flat plates are a photo-mask and a substrate, respectively, which are used in an exposure process in which a pattern drawn on said photo-mask is transferred onto said substrate by irradiating a light through said photo-mask onto said substrate.

12. A method of positional alignment according to any one of Claims 8 - 11, wherein each alignment mark of said at least one set of alignment marks is a formation which is provided within said pattern drawn on said photo-mask for separate purpose.
